# EUROPEAN PATENT SPECIFICATION

(11) **EP 4 465 774 B1**
(45) Date of publication and mention of the grant of the patent: **14.10.2026**
(21) Application number: 23834466.7
(22) Date of filing: 21.04.2023
(51) Int. Cl.: H05K 1/184, H05K 3/341, H05K 1/14, H05K 3/36, H04M 1/02

(54) **CIRCUIT BOARD ASSEMBLY AND ELECTRONIC DEVICE**
LEITERPLATTENANORDNUNG UND ELEKTRONISCHE VORRICHTUNG
ENSEMBLE CARTE DE CIRCUIT IMPRIMÉ ET DISPOSITIF ÉLECTRONIQUE

(30) Priority: 04.07.2022 CN 202221722187 U
(43) Date of publication of application: 20.11.2024
(73) Proprietor: Honor Device Co., Ltd., Shenzhen, Guangdong 518040 (CN)
(72) Inventor: LIU, Tianye, Shenzhen, Guangdong 518040 (CN); YAN, Bin, Shenzhen, Guangdong 518040 (CN); LIU, Xiulan, Shenzhen, Guangdong 518040 (CN)
(74) Representative: MERH-IP Matias Erny Reichl Hoffmann Patentanwälte PartG mbB
(86) International application number: PCT/CN2023/089854
(87) International publication number: WO 2024/007686

(56) References cited:
- CN-A- 107 483 068
- CN-A- 111 771 428
- CN-U- 214 848 757
- CN-U- 218 783 940
- US-A1- 2019 081 422
- US-B1- 7 233 502

## Description

This application claims priority to Chinese Patent Application No. 202221722187.2, filed with the China National Intellectual Property Administration on July 4, 2022 and entitled "CIRCUIT BOARD ASSEMBLY AND ELECTRONIC DEVICE".

### TECHNICAL FIELD

This application relates to the field of electrical devices, and in particular, to a circuit board assembly and an electronic device.

### BACKGROUND

With the development of electronic technologies, for an electronic device such as a mobile phone, to achieve a more extreme appearance effect, bend processing is performed on an edge of a display screen. How to reduce a thickness of the electronic device when the edge of the display screen bends has become an important issue in the industry.

The electronic device in the conventional technology often has a card holder for inserting a SIM card or a component for plugging a plug of an external device. A socket corresponding to the card holder or component is provided on a housing of the electronic device. When the edge of the display screen bends in a direction close to a rear cover, the socket also needs to accordingly move in a direction close to the rear cover, to avoid the bent edge of the display screen. Components such as the card holder need to correspond to a position of the socket on the housing, and therefore, a circuit board on which the components such as the card holder are arranged also needs to move in the direction of the rear cover as a whole, and electronic components on the circuit board also accordingly move as a whole. In this way, the thickness of the electronic device is affected by a component with a higher height on a side surface of the circuit board close to the rear cover. The higher the height of the component, the greater the thickness of the electronic device. This is not beneficial to thinning and lighting of the electronic device.
US 2019/081422 A1discloses a board-to-board connector, including a first circuit board and a second circuit board. The first circuit board has at least one cut. The second circuit board includes a tongue assembly disposed corresponding to the cut, a plurality of connection portions disposed on two opposite surfaces of the tongue assembly, and a plurality of conductive portions electrically connected to the first circuit board.

### SUMMARY

Embodiments of this application provide a circuit board assembly and an electronic device, to resolve a problem in the conventional technology that a thickness of the entire electronic device is large. The technical solution is as provided in the appended claims.

To achieve the foregoing objective, the following technical aspects are used in embodiments of this application.

According to a first aspect, an embodiment of this application provides a circuit board assembly. The circuit board assembly includes a first circuit board, a second component, and a third circuit board. The first circuit board includes a first surface and a second surface that are arranged opposite to each other, where a first component is arranged on the first surface; and at least a part of the second component is arranged on a side of the first circuit board facing away from the first surface, and the second component is configured for plugging at least one of a SIM card and a plug of an external device; and the second circuit board is at least partially arranged on the second surface in a stacking manner, a third component is arranged on the second circuit board, a height of the third component is greater than a height of the first component, and the third component at least partially overlaps with the first circuit board in a thickness direction of the first circuit board.

By using the foregoing solution, in the thickness direction of the first circuit board, the height of the third component protruding from the first circuit board is reduced by a thickness of at least one first circuit board, so that the rear cover can be designed closer to the bottom wall. This helps reduce a thickness of a mobile phone.

In some embodiments, an avoidance opening is provided on the first circuit board, the third component is arranged at the avoidance opening on the second circuit board, and the third component is at least partially located in the avoidance opening.

Compared with arranging the third component outside an edge on a side of the second circuit board on the first circuit board, the foregoing solution reduces an area of the second circuit board located outside the edge on the side of the first circuit board. This further reduces a size (such as a width) of the circuit board assembly in a direction parallel to the first circuit board, which is beneficial to reducing occupation of an accommodating space by the circuit board assembly.

In some embodiments, the avoidance opening runs through the first circuit board in the thickness direction of the first circuit board.

By using the foregoing solution, after the avoidance opening runs through the first circuit board, it is convenient for the third component to run through the avoidance opening.

In some embodiments, the second circuit board includes a first region, the first region extends beyond an edge on a side of the first circuit board, and the third component is arranged in the first region.

By using the foregoing solution, an area for arranging the higher third component on the second circuit board is increased. When there are a plurality of third components, an area for providing an avoidance opening at a position of the first circuit board corresponding to the third component is reduced, and a strength of the first circuit board is improved. When there is one third component, an avoidance opening for the third component to pass through is not provided on the first circuit board. When the thickness of the mobile phone is not affected, manufacturing procedures of the first circuit board are reduced. This further improves flexibility of arranging the third component on the second circuit board.

In some embodiments, a part of the third component is arranged higher than the first surface, and a distance of the third component higher than the first surface is less than the height of the first component.

By using the foregoing solution, the distance protruding from the first surface is determined by the height of the first component that is less than the height of the third component. This is beneficial to reducing a thickness of the entire electronic device.

In some embodiments, there are a plurality of first components and third components, and the distance of each of the third components higher than the first surface is less than a maximum value of the height of the first component.

By using the foregoing solution, a height range of each third component is increased when a distance between the rear cover and the first circuit board is reduced.

In some embodiments, the second component includes a card holder for plugging the SIM card, and the card holder is arranged on the second surface.

By using the foregoing solution, a space between the first circuit board and the bottom wall may be fully utilized. This further improves space utilization of the accommodating space.

In some embodiments, a quantity of second circuit boards is two, and the two second circuit boards are spaced apart to form a limiting groove, and the card holder is arranged in the limiting groove.

By using the foregoing solution, the limiting groove effectively limits movement of the card holder in a direction parallel to the first circuit board. This avoids a case in which the card holder looses in a process of frequent insertion and removal, resulting in poor contact with the first circuit board.

In some embodiments, the second component includes an interface unit for plugging the plug of the external device, the interface unit is arranged on the second circuit board, and a part of the interface unit overlaps with at least one of the first circuit board and the second circuit board in the thickness direction of the first circuit board.

By using the foregoing solution, a case in which a size of the interface unit overlaps with a thickness of the first circuit board and a thickness of the second circuit board is avoided. This is beneficial to reducing an overall size of the circuit board assembly in the thickness direction of the first circuit board.

In some embodiments, a part of the interface unit is higher than the first surface, and a distance of the interface unit higher than the first surface is less than the height of the first component.

By using the foregoing solution, a distance between the first surface and the rear cover is not additionally increased due to the interface unit in the thickness direction of the first circuit board. This improves space utilization of the circuit board assembly in the accommodating space.

In some embodiments, an avoidance space running through the first circuit board and the second circuit board is arranged at a position of the interface unit, one part of the interface unit is arranged on a side surface of the second circuit board facing away from the first circuit board, and the other part of the interface unit is located in the avoidance space.

By using the foregoing solution, a lateral space that is of the first circuit board and the second circuit board and that is occupied by the interface unit may be reduced. This reduces a size (such as a width) of the circuit board assembly in a direction parallel to the first circuit board, which is beneficial to reducing occupation of the accommodating space by the circuit board assembly. In addition, the avoidance space may limit a position of the interface unit, which is beneficial to improving reliability of an electrical connection between the interface unit and the second circuit board.

In some embodiments, the second component is at least partially higher than a third surface, and the third surface is the side surface of the second circuit board facing away from the first circuit board.

By using the foregoing solution, a component with a lower height may be arranged on the third surface. This increases an arrangement area of the component, and optimizes arrangement of the component on the circuit board assembly.

In some embodiments, a fourth component is arranged on the third surface, and a height of the fourth component is less than a maximum value of a distance of the second component higher than the third surface.

By using the foregoing solution, an impact of the fourth component on a thickness of the circuit board assembly is reduced, and an excessive thickness of the circuit board assembly is avoided. This enables arrangement in the accommodating space to be more compact.

In some embodiments, the fourth component includes a conductive elastic piece, the conductive elastic piece is connected to a connecting member, and a part of the connecting member extends beyond an edge of the third surface and extends toward a side of the first circuit board, to be electrically connected to an antenna radiator.

By using the foregoing solution, this helps the conductive elastic piece to be electrically connected to the antenna radiator on a side surface of the circuit board assembly. Then, there is no need to provide fixing holes at positions of the first circuit board and the second circuit board on which the conductive elastic piece is located for the conductive elastic piece to be mounted. This avoids a case in which the fixing holes occupy a space on the first circuit board and the second circuit board.

In some embodiments, both the first circuit board and the second circuit board are rigid circuit boards; and/or the first circuit board is electrically connected to the second circuit board through solder joints.

By using the foregoing solution, additional assembly procedures and positioning structures are not needed, which facilitates assembly and connection of the circuit board assembly, and is beneficial to transformation of the circuit board assembly. In addition, compared with a combination of a rigid circuit and a flexible circuit board, the foregoing solution is beneficial to control a production cost of the circuit board assembly.

According to a second aspect, embodiments of this application provide an electronic device, including a housing, a display screen, and the circuit board assembly according to the first aspect. The housing includes a bottom wall, a side wall arranged at a periphery of the bottom wall, and a rear cover connected to the side wall, where the bottom wall, the side wall, and the rear cover enclose an accommodating space, and a socket that is available to be inserted by a SIM card and a plug of an external device is provided on the side wall; the display screen is arranged on a side of the bottom wall away from the accommodating space, where an edge of the display screen bends toward a side of the rear cover and is connected to the side wall; and the circuit board assembly is arranged in the accommodating space, where the first circuit board is located on a side of the second circuit board close to the rear cover, and the second component is arranged at the socket.

Beneficial effects of the electronic device in embodiments of this application are the same as beneficial effects of the circuit board assembly in the first aspect. This is not described herein again.

### BRIEF DESCRIPTION OF DRAWINGS

FIG. 1 is a schematic diagram of a partial structure of a mobile phone according to some embodiments of this application;
FIG. 2 is an exploded view of the mobile phone in FIG. 1;
FIG. 3 is a structural diagram of a housing in FIG. 2 from one perspective;
FIG. 4 is a simplified cross-sectional view of a connection between a circuit board assembly and a housing in the conventional technology;
FIG. 5 is a simplified cross-sectional view of a connection between a circuit board assembly and a housing according to an embodiment of this application;
FIG. 6 is a structural diagram of a circuit board assembly from one perspective according to an embodiment of this application;
FIG. 7 is an exploded view of the circuit board assembly in FIG. 6 from another perspective;
FIG. 8 is a simplified diagram of a connection between a housing and a circuit board assembly according to some other embodiments of this application;
FIG. 9 is a structural diagram of the circuit board assembly in FIG. 6 from another perspective;
FIG. 10 is an exploded view of a connection structure between a circuit board assembly and a speaker and an antenna board according to some embodiments of this application;
FIG. 11 is a schematic diagram of a partial structure of the circuit board assembly in FIG. 6; and
FIG. 12 is a cross-sectional view of A-A in FIG. 6.

### DESCRIPTION OF EMBODIMENTS

In embodiments of this application, terms "first" and "second" are used merely for the purpose of description, and shall not be construed as indicating or implying relative importance or implying a quantity of indicated technical features. Therefore, a feature limited by "first" or "second" may explicitly or implicitly include one or more features.

In embodiments of this application, it should be noted that, a term "electrical connection" should be understood in a broad sense. For example, current conduction may be implemented in a manner of direct connection, or conduction of electrical energy may be implemented in a manner of capacitive coupling.

An electronic device in embodiments of this application may be an electronic device into which a SIM card needs to be inserted or an electronic device that includes a component for plugging a plug of an external device such as a mobile phone, a tablet computer, an e-reader, a wearable device, a remote control, a POS (point of sales terminal; and point of sales information management system) machine, a notebook computer, a personal digital assistant (personal digital assistant, PDA), or a vehicle-mounted device.

The following describes the electronic device in embodiments of this application in detail by using the mobile phone as an example. Other types of electronic devices may be specifically configured with reference to a design concept of a circuit board assembly 10 in a mobile phone embodiment. Details are not described herein again.

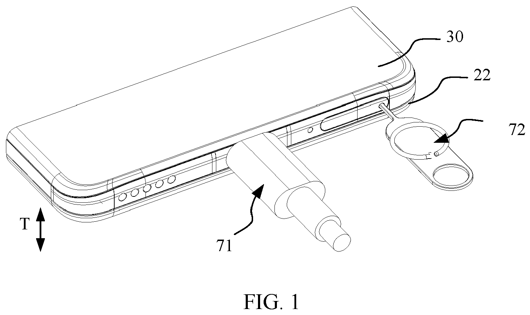

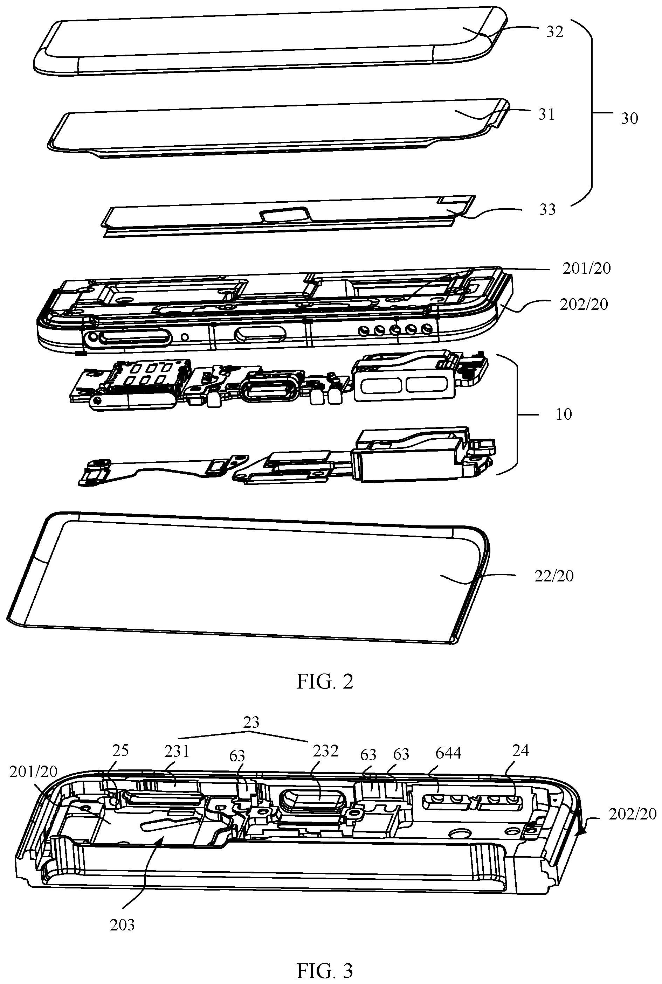

FIG. 1 is a schematic diagram of a partial structure of a mobile phone according to some embodiments of this application. FIG. 2 is an exploded view of the mobile phone in FIG. 1. FIG. 3 is a partial structural view of a housing 20 in FIG. 2 from another perspective. The mobile phone includes a housing 20, a display screen 30, and a circuit board assembly 10.

As shown in FIG. 2 and FIG. 3, the housing 20 includes a bottom wall 201, a side wall 202 arranged at a periphery of the bottom wall 201, and a rear cover 22 connected to the side wall 202, where the bottom wall 201, the side wall 202, and the rear cover 22 enclose an accommodating space 203, the circuit board assembly 10 is arranged in the accommodating space 203, and a socket 23 is provided on the side wall 202. For example, the socket 23 includes a first socket 231 for plugging a SIM card and a second socket 232 for plugging a plug 71 of an external device. The display screen 30 is arranged on a side of the bottom wall 201 away from the accommodating space 203. An edge of the display screen 30 bends toward a side of the rear cover 22 and is connected to the side wall 202.

Both a material of the bottom wall 201 and a material of the side wall 202 may be metal or a combination of metal and plastic. The metal part may be used as an antenna radiator 63. The antenna radiator 63 is configured to transmit and receive electromagnetic wave signals. The bottom wall 201 and the side wall 202 may be fixed by bonding or soldering. This is not specifically limited herein.

The display screen 30 is electrically connected to the circuit board assembly 10, and is configured to display images, text, and the like. The display screen 30 is a flexible screen. For example, the display screen 30 is an OLED (Organic Light-Emitting Diode; and organic light-emitting diode) screen. The display screen 30 includes a display panel 31, a protective cover plate 32, and a backplane 33. The display panel 31 is arranged on a side of the bottom wall 201 away from the accommodating space 203. The protective cover plate 32 is attached to a side of the display panel 31 away from the bottom wall 201, to protect the display panel 31. The protective cover plate 32 is a flexible glass plate, and an edge of the protective cover plate 32 bends toward a side of the rear cover 22 and is connected to the side wall 202. The backplane 33 is connected to a side of the display panel 31 close to the bottom wall 201 and is connected to the bottom wall 201, to protect the display panel 31 and dissipate heat.

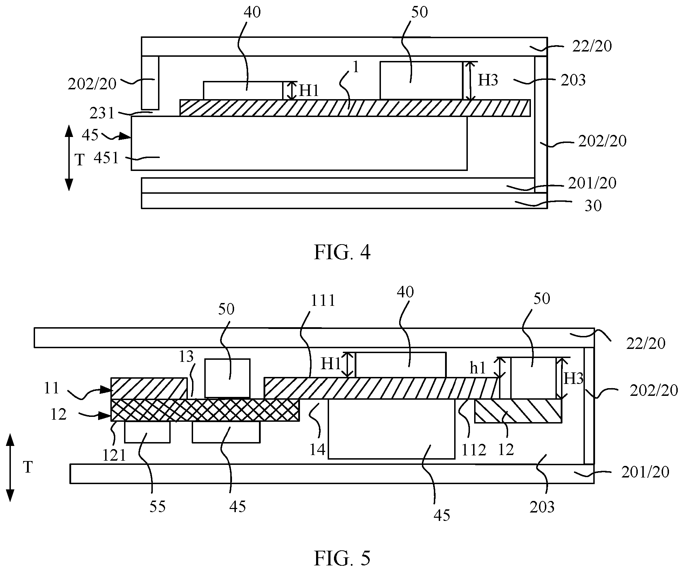

FIG. 4 is a simplified cross-sectional view of a connection between a circuit board assembly 10 and a housing 20 in the conventional technology. The circuit board assembly 10 in the conventional technology includes a circuit board 1 and a first component 40, a second component 45, and a third component 50 that are arranged on the circuit board 1. The first component 40 and the third component 50 are arranged on a side surface of the circuit board 1 close to a rear cover 22, and a height H3 of the third component 50 is greater than a height H1 of the first component 40; and the second component 45 is arranged on a side surface of the circuit board 1 away from the rear cover 22, and the second component 45 includes a card holder 451 for plugging a SIM card.

When an edge of a display screen 30 bends in a direction close to the rear cover 22, a first socket 231 also needs to accordingly move in a direction close to the rear cover 22, to avoid a bent edge of the display screen 30. Since the card holder 451 corresponds to a position of the first socket 231 that is for plugging the SIM card and that is on a side wall 202, the circuit board 1 on which the second component 45 is arranged also needs to move as a whole in a direction close to the rear cover 22. In this way, a thickness of a mobile phone is affected by the third component 50 with a higher height on a side surface of the circuit board 1 close to the rear cover 22. The higher the height of the third component 50 is, the farther the rear cover 22 needs to be designed to be away from the bottom wall 201, and the thicker the mobile phone is, which is not beneficial to thinning and lighting of the mobile phone.

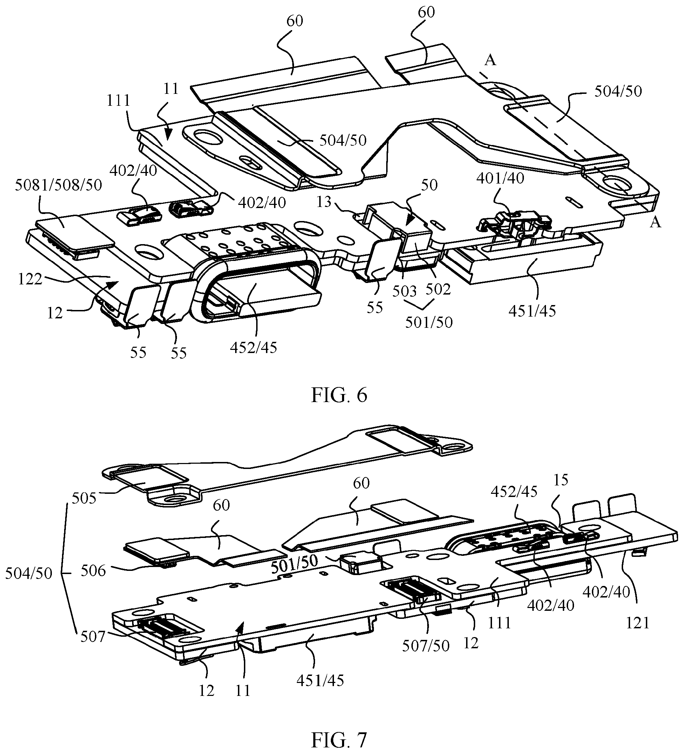

FIG. 5 is a simplified cross-sectional view of a connection between a circuit board assembly 10 and a housing 20 according to an embodiment of this application. FIG. 6 is a structural diagram of a circuit board assembly 10 from one perspective according to an embodiment of this application. FIG. 7 is an exploded view of the circuit board assembly 10 in FIG. 6 from another perspective. It should be noted that, FIG. 5 only schematically shows a simplified structural diagram of a circuit board assembly 10 and a schematic diagram of a connection of a housing 20 according to some embodiments of this application, but a structure of the circuit board assembly 10 is not limited to that shown in FIG. 5. The circuit board assembly 10 includes: a first circuit board 11, a second component 45, and a second circuit board 12. The first circuit board 11 is located on a side of the second circuit board 12 close to a rear cover 22.

The first circuit board 11 includes a first surface 111 and a second surface 112 that are arranged opposite to each other. A first component 40 is arranged on the first surface 111, a second component 45 is arranged at a socket 23, and at least a part of the second component 45 is arranged on a side of the first circuit board 11 facing away from the first surface 111. A part of the second circuit board 12 is arranged on the second surface 112 in a stacking manner. A third component 50 is arranged on the second circuit board 12. A height H3 of the third component 50 is greater than a height H1 of the first component 40, and the third component 50 overlaps with the first circuit board 11 in a thickness direction T of the first circuit board 11.

In embodiments of this application, "overlap" specifically means that sizes of two components in a specific direction overlap with each other to a specific extent. For example, that the third component 50 overlaps with the first circuit board 11 in the thickness direction T of the first circuit board 11 means: A size of the first circuit board 11 overlaps with a size of the third component 50 to a specific extent in the thickness direction T of the first circuit board 11. In other words, orthographic projections of the first circuit board 11 and the third component 50 on a plane perpendicular to the first circuit board 11 have overlapping regions.

By using the foregoing technical solution, in the thickness direction T of the first circuit board 11, a height of the third component 50 protruding from the first circuit board 11 is reduced by a thickness of at least one first circuit board 11, so that the rear cover 22 can be designed closer to a bottom wall 201. This helps reduce a thickness of a mobile phone.

In some embodiments, as shown in FIG. 5 and FIG. 6, both the first circuit board 11 and the second circuit board 12 are rigid circuit boards. In this way, additional assembly procedures and positioning structures are not needed, which facilitates assembly and connection of the circuit board assembly 10, and is beneficial to transformation of the circuit board assembly 10. In addition, in comparison to a combination of the first circuit board 11 being a rigid circuit board and the second circuit board 12 being a flexible circuit board, an area for arranging components is increased, and a production cost of the rigid circuit board is lower, which is beneficial to controlling a production cost of the circuit board assembly 10.

In some embodiments, as shown in FIG. 6, the first circuit board 11 is electrically connected to the second circuit board 12 through a solder material. In this way, the first circuit board 11 is fixedly connected to the second circuit board 12 through the solder material, and the solder material plays a structural fixing role. In addition, the first circuit board 11 may be electrically connected to the second circuit board 12 through the solder material, and the solder material plays a role of signal communication, so that a function of the circuit board assembly 10 is consistent with a function of arranging all components on one circuit board.

The solder material may be in the form of dots, so that after the second circuit board 12 and the first circuit board 11 are soldered by the solder material, a distance between soldering surfaces of the first circuit board 11 and the second circuit board 12 may be effectively controlled, so that the second circuit board 12 is more attached to the second surface 112 of the first circuit board 11. In other words, in the thickness direction T of the first circuit board 11, a distance between the second circuit board 12 and the second surface 112 of the first circuit board 11 is negligible. A position of the solder material on the second surface 112 may be selected by a user on the premise of ensuring reliability of a connection between the first circuit board 11 and the second circuit board 12. This is not specifically limited herein.

Certainly, in addition to being electrically connected to each other through the solder material, the first circuit board 11 and the second circuit board 12 may also be electrically connected to each other through a wire or a conductive component. The conductive component may be a conductive pin or a conductive elastic piece. This is not specifically limited herein.

In some embodiments, as shown in FIG. 5 to FIG. 7, an avoidance opening 13 is provided on the first circuit board 11, the third component 50 is arranged at the avoidance opening 13 on the second circuit board 12, and a part (certainly, all) of the third component 50 is located at the avoidance opening 13. Compared with arranging the third component 50 outside an edge on a side of the second circuit board 12 on the first circuit board 11, this reduces an area of the second circuit board 12 located outside the edge on the side of the first circuit board 11. This further reduces a size (such as a width) of the circuit board assembly 10 in a direction parallel to the first circuit board 11, which is beneficial to reducing occupation of an accommodating space 203 by the circuit board assembly 10.

In addition, a quantity of avoidance openings 13 may be the same as a quantity of third components 50, and the avoidance openings 13 are in one-to-one correspondence with the third components 50. One or more third components 50 may also be arranged at one avoidance opening 13. This is not specifically limited herein.

In some embodiments, as shown in FIG. 7, the avoidance opening 13 runs through the first circuit board 11 in the thickness direction T of the first circuit board 11. After the avoidance opening 13 runs through the first circuit board 11, it is convenient for the third component 50 to run through the avoidance opening 13.

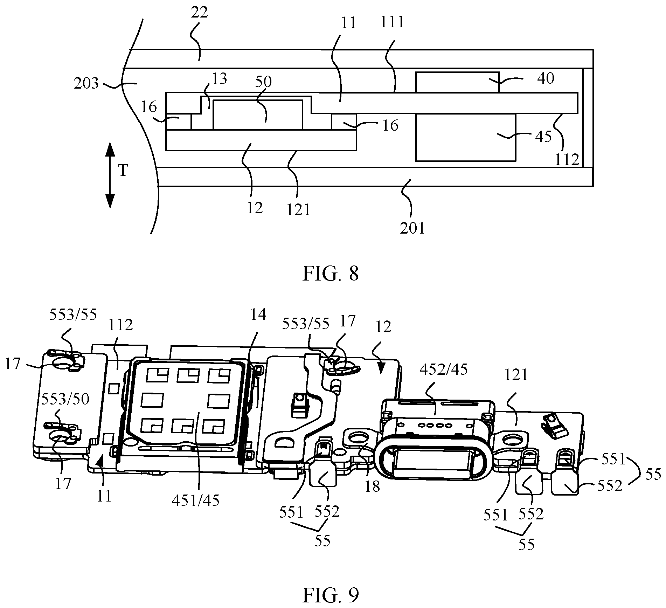

Certainly, in addition to running through the first circuit board 11, the avoidance opening 13 may also not run through the first circuit board 11, as shown in FIG. 8. This is not specifically limited herein.

In some embodiments, FIG. 8 is a simplified diagram of a connection between a housing 20 and a circuit board assembly 10 according to some other embodiments of this application. A first circuit board 11 and a second circuit board 12 are arranged in a stacking manner through an elevated board 16.

By arranging the elevated board 16, a component with a higher height may be arranged between the first surface 111 and the second circuit board 12, to increase an area for arranging components. In addition, by arranging the elevated board 16 with the first circuit board 11 and the second circuit board 12 in a stacking manner, stability and reliability of a connection between the first circuit board 11 and the second circuit board 12 are improved.

In some embodiments, as shown in FIG. 8, in a thickness direction T of the first circuit board 11, a third component 50 is arranged on a side surface of the second circuit board 12 close to the first circuit board 11, and is located between the first circuit board 11 and the second circuit board 12. A sum of a thickness of the elevated board 16 and a thickness of the second circuit board 12 is less than a height of a second component 45. In this way, in the thickness direction T of the first circuit board 11, when a size (such as a width) of the circuit board assembly 10 in a direction parallel to the first circuit board 11 is reduced, through elevation of the elevated board 16, an area for arranging the third component 50 with a higher height on the two opposite surfaces of the second circuit board 12 is increased.

In some embodiments, as shown in FIG. 5 and FIG. 6, a part of the third component 50 is arranged higher than the first surface 111, and a distance h1 of the third component 50 higher than the first surface 111 is less than a height H1 of a first component 40. In this way, a distance protruding from the first surface 111 is determined by the height of the first component 40 with a lower height. In this way, a rear cover 22 can be designed closer to a bottom wall 201, which is beneficial to reducing a thickness of a mobile phone.

Certainly, in addition to a case in which the distance h1 of the third component 50 higher than the first surface 111 is less than the height H1 of the first component 40, the distance h1 of the third component 50 higher than the first surface 111 may also be equal to the height H1 of the first component 40. This is not specifically limited herein.

In some embodiments, as shown in FIG. 6, the second circuit board 12 includes a first region 122, the first region 122 extends beyond an edge on a side of the first circuit board 11, and the third component 50 is arranged in the first region 122.

By using the foregoing technical solution, an area for arranging the third component 50 with a higher height on the second circuit board 12 is increased. When there is one third component 50, the third component 50 is arranged on the first region 122, and a case of opening an avoidance opening 13 on the first circuit board 11 for the third component 50 to pass through is avoided. When the thickness of the mobile phone is not affected, manufacturing procedures of the first circuit board 11 are reduced. When there are a plurality of third components 50, one part of the plurality of third components 50 may be arranged on the first region 122, and the other part of third components 50 are arranged on the second circuit board 11 and protrude from the first surface 111 through the avoidance opening 13 on the first circuit board 11. In comparison to a case in which the plurality of third components 50 pass through the first circuit board 11 through the avoidance opening 13, an area for providing the avoidance opening 13 at the position of the first circuit board 11 corresponding to the third component 50 is reduced, and a strength of the first circuit board 11 is improved, thereby improving flexibility of arrangement of the third component 50 on the second circuit board 12.

As shown in FIG. 7 and FIG. 9, FIG. 9 is a structural diagram of the circuit board assembly 10 in FIG. 6 from another perspective. The second component 45 is higher than a third surface 121, where the third surface 121 is a side surface of the second circuit board 12 facing away from the first circuit board 11.

In this way, without increasing a thickness of the circuit board assembly 10, a component with a lower height may be arranged on the third surface 121. This increases an area for arranging components, and optimizes arrangement of the components on the circuit board assembly 10.

In some embodiments, as shown in FIG. 6 and FIG. 9, the second component 45 includes a card holder 451 for plugging a SIM card, and the card holder 451 is arranged on the second surface 112. In this way, arrangement of the card holder 451 makes full use of a space between the first circuit board 11 and the bottom wall 201, and avoids wasting the space between the first circuit board 11 and the bottom wall 201. This improves space utilization of an accommodating space 203.

Certainly, in addition to being arranged on the second surface 112, the card holder 451 may also be arranged on a side surface of the second circuit board 12 close to the second surface 112. This is not specifically limited herein.

The card holder 451 is used in this way. The card holder 451 passes through a socket 23 provided on a side wall 202, and a pin 72 is inserted through an insertion hole 25 provided on the side wall 202, so that the card holder 451 pops out of a housing 20. After the SIM card is placed into the card holder 451, the card holder 451 moves toward the inside of the housing 20 in a direction of the inside of the housing 20. When the SIM card needs to be taken out, the pin 72 is also used to pop the card holder 451 out of the housing 20. This is not described herein again.

In some embodiments, as shown in FIG. 5 and FIG. 9, a quantity of second circuit boards 12 is two, the two second circuit boards 12 are spaced apart to form a limiting groove 14, and the card holder 451 is arranged in the limiting groove 14. The two second circuit boards 12 are spaced apart to form the limiting groove 14. When stability and reliability of a connection between the first circuit board 11 and the second circuit board 12 are improved, the limiting groove 14 effectively limits movement of the card holder 451 in a direction perpendicular to a thickness direction T of the first circuit board 11. This avoids a case in which the card holder 451 looses in a process of frequent insertion and removal, resulting in poor contact with the first circuit board 11.

In addition to a case in which a quantity of second circuit boards 12 is two, a quantity of second circuit boards 12 may also be one, three, four, and the like. For example, there is one second circuit board 12, and the limiting groove 14 is provided on the second circuit board 12 at a position corresponding to the card holder 451. In this way, a quantity of components of the circuit board assembly 10 is reduced, and overall functional consistency of the circuit board assembly 10 is improved.

In some embodiments, as shown in FIG. 6 and FIG. 9, the second component 45 includes an interface unit 452 for plugging a plug 71 of the external device, the interface unit 452 is arranged on the second circuit board 12, and a part of the interface unit 452 overlaps with the first circuit board 11 and the second circuit board 12 in the thickness direction T of the first circuit board 11. In this design, a case in which a size of the interface unit 452 overlaps with a thickness of the first circuit board 11 and a thickness of the second circuit board 12 is avoided. This is beneficial to reducing an overall size of the circuit board assembly 10 in the thickness direction T of the first circuit board 11.

The interface unit 452 may be configured to be connected to an external power supply device for charging the mobile phone. The interface unit 452 may be any one of a Type-C interface, a Micro-USB interface, and a Mini-USB interface. This is not specifically limited herein. Certainly, in addition to being configured to be connected to the external power supply device for charging the mobile phone, the interface unit 452 may also be a USB interface or a headphone interface. This is not specifically limited herein.

It should be noted that, a part of the interface unit 452 may overlap with both the first circuit board 11 and the second circuit board 12, or may overlap with one of the first circuit board 11 or the second circuit board 12.

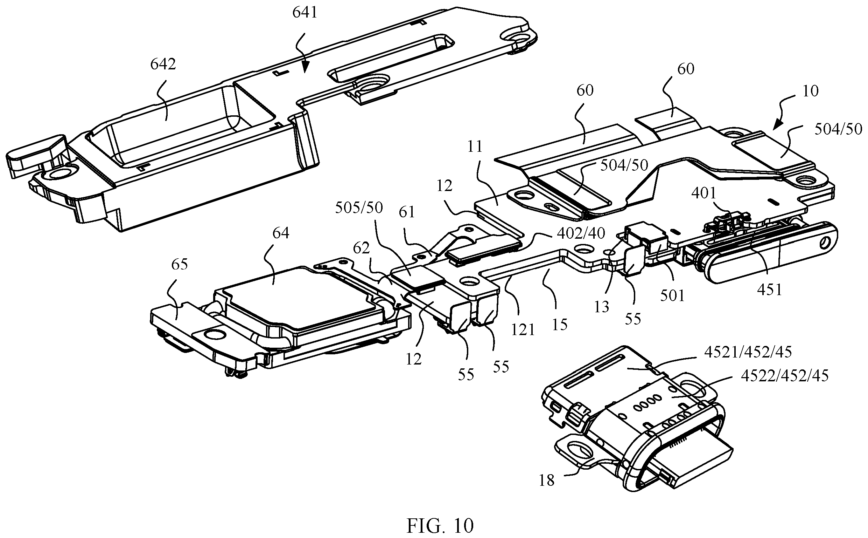

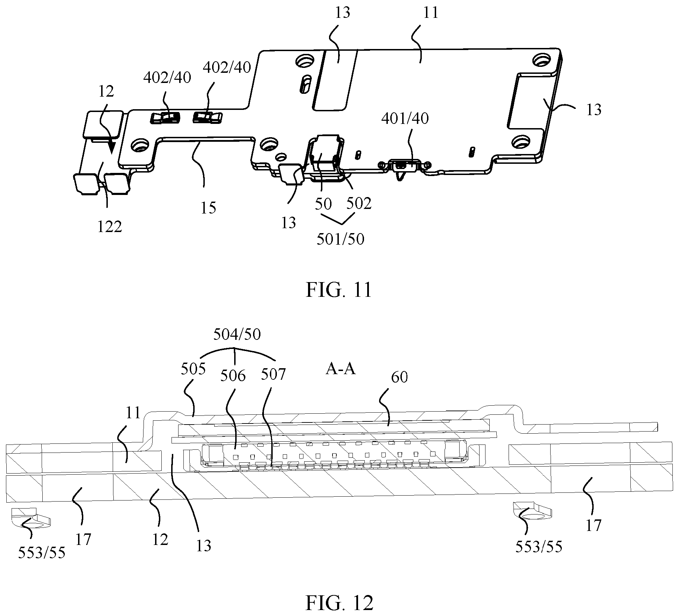

FIG. 10 is an exploded view of a connection structure between a circuit board assembly 10 and a speaker 64 and an antenna board 65 according to some embodiments of this application. FIG. 11 is a schematic diagram of a partial structure of the circuit board assembly 10 in FIG. 6. An avoidance space 15 that runs through the first circuit board 11 and the second circuit board 12 is arranged at a position of an interface unit 452. One part (referring to a connecting part 4521 of the interface unit 452) of the interface unit 452 is arranged on a third surface 121. The other part (referring to a slot portion 4522 where a plug 73 of an external device is plugged into the interface unit 452) of the interface unit 452 is located in the avoidance space 15. The third surface 121 is a side surface of the second circuit board 12 facing away from the first circuit board 11.

By arranging a part of the interface unit 452 in the avoidance space 15, a lateral space that is of the first circuit board 11 and the second circuit board 12 and that is occupied by the interface unit 452 may be reduced. This reduces a size (such as a width) of the circuit board assembly 10 in a direction parallel to the first circuit board 11, which is beneficial to reducing occupation of the accommodating space 203 by the circuit board assembly 10. In addition, the avoidance space 15 may limit a position of the interface unit 452, which is beneficial to improving reliability of an electrical connection between the interface unit 452 and the second circuit board 12.

Certainly, the interface unit 452 may also be arranged on the second surface 112, toward a side of the second circuit board 12, or the interface unit 452 may be arranged on a side surface of the second circuit board 12 close to the second surface 112, toward a side of the first surface 111 or a side of the third surface 121. This is not specifically limited herein.

In some embodiments, as shown in FIG. 6, a part of the interface unit 452 is higher than the first surface 111, and a distance of the interface unit 452 higher than the first surface 111 is less than the height of the first component 40. For example, a distance of the interface unit 452 higher than the first surface 111 is less than a height of a second elastic piece 402. In this way, in a thickness direction T of the first circuit board 11, the interface unit 452 is still determined by a component with a highest height among the first components 40 with lower heights. A distance between the first surface 111 and the rear cover 22 is not additionally increased due to the interface unit 452. This improves space utilization of the circuit board assembly 10 in the accommodating space 203.

In some embodiments, as shown in FIG. 9 and FIG. 10, an end of the interface unit 452 that is for plugging of the external device is fixed on the third surface 121 through a connecting ear 18. The connecting ear 18 concaves toward a side facing the first surface 111 and overlaps with the third surface 121, so that the end of the interface unit 452 that is for plugging of the external device is located in an avoidance space 15. Arrangement of the connecting ear 18 well limits movement of the interface unit 452 in a direction parallel to the first circuit board 11. This improves reliability of an electrical connection between the interface unit 452 and the second circuit board 12, and improves reliability of the circuit board assembly 10.

In some embodiments, as shown in FIG. 5 to FIG. 7, there are a plurality of first components 40 and third components 50, and the distance of each of the third components 50 higher than the first surface 111 is less than a maximum value of the height of the first component 40.

By using the foregoing solution, a height range of each third component 50 is increased when a distance between the rear cover 22 and the first circuit board 11 is reduced.

In some embodiments, as shown in FIG. 3 and FIG. 6, a plurality of first components 40 are respectively a first elastic piece 401 and a second elastic piece 402. The first elastic piece 401 is arranged at an edge of the first surface 111, and is configured to be electrically connected to an antenna radiator 63, and the second elastic piece 402 is configured to be electrically connected to a speaker 64. The antenna and the speaker 64 are electrically connected to the first circuit board 11 through the first elastic piece 401 and the second elastic piece 402 respectively. When reliability of the electrical connection between the antenna and the speaker 64 and the first circuit board 11 is ensured, it is convenient for a user to operate and a cost is low.

As shown in FIG. 10, the speaker 64 includes a lower cover body 641, a speaker driver 643, and a second flexible circuit board 61. The lower cover body 641 has a cavity 642. The speaker driver 643 is arranged in the cavity 642. One end of the second flexible circuit board 61 is electrically connected to the speaker driver 643, and the other end of the second flexible circuit board 61 is electrically connected to the circuit board assembly 10 through the second elastic piece 402. In this case, the lower cover body 641 is fixed to the bottom wall 201, so that the speaker 64 is fixed to the housing 20. In this case, a space enclosed by the cavity 642 and the bottom wall 201 of the housing 20 forms a sound cavity. In this way, the speaker 64 is closely attached to the bottom wall 201, which saves a space of an accommodating space 203 occupied by an upper cover body, and further reduces a thickness of the mobile phone.

As shown in FIG. 3, a sound output hole 24 is provided on the side wall 202 of the housing 20 corresponding to a sound output portion of the sound cavity of the speaker 64. The sound output hole 24 is configured to release sound emitted by the speaker driver 643 out of the housing 20. A dust-proof net 644 is arranged between the sound output hole 24 and the sound output portion of the sound cavity. By arranging the dust-proof net 644, metal particles and other dust are prevented from entering the speaker 64 through the sound output hole 24, to reduce an impact of dust on performance of the speaker 64. A quantity of sound output holes 24 needs to be determined based on factors such as a size of the side wall 202 of the housing 20, and arrangement of the speaker driver 643 and the sound cavity. This is not specifically limited herein.

As shown in FIG. 6, FIG. 7, FIG. 10, and FIG. 12, FIG. 12 is a cross-sectional view of A-A in FIG. 6. A plurality of third components 50 are a microphone component 501, a connector assembly 504, and an antenna connector assembly 508 respectively.

As shown in FIG. 6, the microphone component 501 includes a microphone 502 and a shielding case 503. The shielding case 503 is arranged on the second circuit board 12, and the microphone 502 is arranged in the shielding case 503. Specifically, an avoidance opening 13 running through the first circuit board 11 is provided on a side of the first circuit board 11, and the microphone component 501 is located in the avoidance opening 13 as a whole.

It should be noted that, when both the microphone 502 and the shielding case 503 are arranged on a side surface of the second circuit board 12 close to the second surface 112, a height of the microphone component 501 is a height of the shielding case 503. In other words, the height of the microphone component 501 is a distance between the side surface of the second circuit board 12 close to the second surface 112 and a highest point of an outer bottom wall 201 of the shielding case 503. For example, the height of the microphone component 501 is greater than a height of the first elastic piece 401, the microphone component 501 is higher than the first surface 111, and the height of the microphone component 501 higher than the first surface 111 is less than the height of the first component 40 such as the first elastic piece 401.

As shown in FIG. 7 and FIG. 12, the connector assembly 504 includes a fixing member 505, a first connector 506 arranged on the second circuit board 12, and a second connector 507 configured to be connected to the first flexible circuit board 60. The second connector 507 is electrically connected to the first connector 506, and the fixing member 505 is configured to relatively fix the second connector 507 and the first connector 506. In this case, the second connector 507 and the first connector 506 are located in the avoidance opening 13.

It should be noted that, a structure of the fixing member 505 is in a plate shape. The first connector 506 and the second connector 507 may be male and female sockets of a BTB connector. The first connector 506 is connected to the second connector 507 through the fixing member 505, so that the circuit board assembly 10 is electrically connected to a main board. A height of the connector assembly 504 includes a distance between a highest point of a side surface of the fixing member 505 away from the second circuit board 12 and a side surface of the second circuit board 12 on which the second connector 507 is located.

In some embodiments, as shown in FIG. 7, there are two first flexible circuit boards 60 and two connector assemblies 504. Because a distance between the two connector assemblies 504 is close, to reduce a quantity of components of the circuit board assembly 10, fixing members 505 in the two connector assemblies 504 are processed into an integrated plate-shaped structure. In this way, the fixing member 505 lays the first flexible circuit board 60 on the first surface 111 of the first circuit board 11, to avoid damage to the first flexible circuit board 60 in an assembly process of the circuit board assembly 10. This improves reliability of an electrical connection between the first flexible circuit board 60 and the circuit board assembly 10.

Certainly, two fixing members 505 may also be correspondingly arranged. This is not specifically limited herein.

As shown in FIG. 6 and FIG. 10, an antenna connector assembly 508 includes a connector body 5081 and a pressing plate 5082 that are arranged on the second circuit board 12. For example, the connector body 5081 is arranged on a first region 122 of the second circuit board 12. One end of the third flexible circuit board 62 is electrically connected to the antenna connector assembly 508 through the pressing plate 5082. The other end of the third flexible circuit board 62 is electrically connected to an antenna board 65, so that the antenna board 65 is electrically connected to the circuit board assembly 10. For example, the pressing plate 5082 and the lower cover body 641 of the speaker 64 are an integral structure. This setting reduces a quantity of components of the mobile phone.

Because the third flexible circuit board 62 may be electrically connected to the circuit board assembly 10 in a manner of bending, folding, and the like, so that the third flexible circuit board 62 matches an internal space of the accommodating space 203, has better flexibility, and takes up less space than a hard circuit board. This saves an ultrasonic soldering procedure, and further reduces an assembly cost of the circuit board assembly 10.

A quantity of antenna boards 65 may be one or more, to increase feed points of an antenna, and improve a signal strength of the antenna. A specific quantity and position of the antenna board 65 are selected based on actual needs. This is not specifically limited herein.

In some embodiments, as shown in FIG. 5 and FIG. 9, a fourth component 55 is arranged on the third surface 121, and a height of the fourth component 55 is less than a maximum value of a distance of the second component 45 higher than the third surface 121. In this way, a thickness of the circuit board assembly 10 (namely, a size of the circuit board assembly 10 in a thickness direction T of the first circuit board 11) is related to a height of the second component 45 arranged on the second surface 112. An impact of the fourth component 55 on a thickness of the circuit board assembly 10 is reduced, and an excessive thickness of the circuit board assembly 10 is avoided. This enables arrangement in the accommodating space 203 to be more compact.

In some embodiments, as shown in FIG. 9, the fourth component 55 includes a conductive elastic piece 551, the conductive elastic piece 551 is connected to a connecting member 552, and a part of the connecting member 552 extends beyond an edge of the third surface 121 and extends toward a side of the first circuit board 11, to be electrically connected to an antenna radiator 63.

In comparison to a case in which the conductive elastic piece 551 is directly electrically connected to the antenna radiator 63, the connecting member 522 is arranged. This helps the conductive elastic piece 551 to be electrically connected to the antenna radiator 63 on a side surface of the circuit board assembly 10. Then, there is no need to provide fixing holes at positions of the first circuit board 11 and the second circuit board 12 on which the conductive elastic piece 551 is located for the conductive elastic piece 551 (which is similar to a mounting structure of the first elastic piece 401 in FIG. 6) to be mounted. This avoids a case in which the fixing holes occupy a space on the first circuit board 11 and the second circuit board 12.

The conductive elastic piece 551 and the connecting member 552 may be integrally formed, or may be separate structures connected by soldering or conductive bonding. This is not specifically limited herein.

In some embodiments, as shown in FIG. 3 and FIG. 9, there are a plurality of conductive elastic pieces 551 and connecting members 552, and each conductive elastic piece 551 is connected to one connecting member 552, and is electrically connected to one antenna radiator 63. A plurality of antenna radiators 63 are arranged on the side wall 202 and are spaced apart in a circumferential direction of the bottom wall 201. Each connecting member 552 is electrically connected to one antenna radiator 63, to form a feed point of an antenna. Arrangement of the plurality of antenna radiators 63 increases feed points of the antenna, and improves a signal strength of the antenna.

In some embodiments, as shown in FIG. 9, the fourth component 55 further includes a conductive member 553, and the conductive member 553 is electrically connected to a metal part of the bottom wall 201. Specifically, a mounting hole 17 is provided on the second circuit board 12, and the conductive member 553 is arranged on a periphery of the mounting hole 17. After a fastener passes through the mounting hole 17 to connect the circuit board assembly 10 to the bottom wall 201, the conductive member 553 is electrically connected to the metal part of the bottom wall 201. The foregoing fastener may be a screw or a bolt. This is not specifically limited herein.

The conductive member 553 may be configured for feeding or grounding of the antenna. For example, the conductive member 553 may be a large elastic piece. A quantity of conductive members 553 may be one, and the conductive member 553 is arranged at one mounting hole 17; and a quantity of conductive members 553 may also be more than one. In other words, one conductive member 553 is arranged at each mounting hole 17, to improve reliability of an electrical connection between the circuit board assembly 10 and the bottom wall 201. Certainly, the conductive member 553 may also be a metal spring, or the like. This is not specifically limited herein.

In the descriptions of this specification, the described specific features, structures, materials, or characteristics may be combined in a proper manner in any one or more of the embodiments or examples.

The foregoing embodiments are merely intended for describing the technical solutions of this application, but not for limiting this application. Although this application is described in detail with reference to the foregoing embodiments, a person of ordinary skill in the art is to understand that they may still make modifications to the technical solutions described in the foregoing embodiments or make equivalent replacements to some technical features thereof, without departing from the scope of the technical solutions of embodiments of this application according to the claims.

## Claims

1. An electronic device, comprising:
a housing (20), wherein the housing (20) comprises a bottom wall (201), a side wall (202), and a rear cover (22), the side wall (202) is arranged at a periphery of the bottom wall (201), the rear cover (22) is connected to the side wall (202), wherein the bottom wall (201), the side wall (202), and the rear cover (22) enclose an accommodating space (203);
a circuit board assembly (10), wherein the circuit board assembly (10) is arranged in the accommodating space (203), and the circuit board assembly (10) comprises a first circuit board (11), a second circuit board (12), a first conductive elastic piece (401), and a connector assembly (50);
**characterized in that**
the first circuit board (11) comprises a first surface (111) and a second surface (112) and is provided with an avoidance opening (13), the first surface (111) and the second surface (112) are arranged opposite to each other, the first conductive elastic piece (401) is arranged on the first surface (111);
the second circuit board (12) is at least partially arranged on the second surface (112) in a stacking manner, the second circuit board (12) comprises a third surface, the third surface is a side surface of the second circuit board (12) facing the first circuit board (11), the connector assembly (50) is arranged on the third surface, the connector assembly (50) is at least partially located in the avoidance opening (13), and a height of the connector assembly (50) is greater than a height of the first conductive elastic piece (401).

2. The electronic device according to claim 1, wherein the avoidance opening (13) runs through the first circuit board (11) in a thickness direction of the first circuit board (11).

3. The electronic device according to claim 1 or 2, wherein the second circuit board (12) comprises a first region (122), the first region (122) extends beyond an edge on a side of the first circuit board (11), and the connector assembly (50) is arranged in the first region (122).

4. The electronic device according to any one of claims 1 to 3, wherein a part of the connector assembly (50) is arranged higher than the first surface (111).

5. The electronic device according to any one of claims 1 to 4, wherein the second circuit board (12) comprises a fourth surface (121), and the fourth surface (121) is a side surface of the second circuit board (12) facing away from the first circuit board (11).

6. The electronic device according to any one of claim 1 to 5, wherein the connector assembly (50) at least partially overlaps with the first circuit board (11) in the thickness direction of the first circuit board (11).

7. The electronic device according to any one of claims 1 to 6, wherein the circuit board assembly (10) further comprises a card holder (451), the card holder (451) is arranged on the second surface (112), and the card holder (451) is configured for plugging a SIM card.

8. The electronic device according to claim 7, wherein a first socket (231) is provided on the side wall (202), and the card holder (451) is further arranged at the first socket (231).

9. The electronic device according to claim 8, wherein the electronic device further comprises an interface unit (452), at least a part of the interface unit (452) is arranged on a side of the first circuit board (11) facing away from the first surface (111), and the interface unit (452) is configured for plugging a plug of an external device.

10. The electronic device according to claim 9, wherein a second socket (232) is provided on the side wall (202), and the interface unit (452) is further arranged at the second socket (232).

11. The electronic device according to claim 10, wherein a part of the interface unit (452) is higher than the first surface (111), and a distance of the interface unit (452) higher than the first surface (111) is less than the height of the first conductive elastic piece (401).

12. The electronic device according to claim 11, wherein the card holder (451) and the interface unit (452) are at least partially higher than the fourth surface (121).

13. The electronic device according to any one of claims 9 to 12, wherein the circuit board assembly (10) further comprises a second conductive elastic piece (402), the second conductive elastic piece (402) is arranged on the fourth surface (121), and a height of the second conductive elastic piece (402) is less than a distance of the card holder (451) or the interface unit (452) higher than the fourth surface (121).

14. The electronic device according to any one of claims 7 to 13, wherein a quantity of second circuit boards is two, two second circuit boards are spaced apart, and the card holder (451) is arranged between the two second circuit boards.

15. The electronic device according to any one of claims 1 to 14, wherein both the first circuit board (11) and the second circuit (12) board are rigid circuit boards.

## Patentansprüche

1. Elektronische Vorrichtung, umfassend:
ein Gehäuse (20), wobei das Gehäuse (20) eine Bodenwand (201), eine Seitenwand (202) und eine Rückabdeckung (22) umfasst, wobei die Seitenwand (202) an einem Umfang der Bodenwand (201) angeordnet ist, wobei die Rückabdeckung (22) mit der Seitenwand (202) verbunden ist, wobei die Bodenwand (201), die Seitenwand (202) und die Rückabdeckung (22) einen Aufnahmeraum (203) umschließen;
eine Leiterplattenanordnung (10), wobei die Leiterplattenanordnung (10) in dem Aufnahmeraum (203) angeordnet ist, und wobei die Leiterplattenanordnung (10) eine erste Leiterplatte (11), eine zweite Leiterplatte (12), ein erstes leitfähiges elastisches Teil (401) und eine Verbinderanordnung (50) umfasst; **dadurch gekennzeichnet, dass**
die erste Leiterplatte (11) eine erste Oberfläche (111) und eine zweite Oberfläche (112) umfasst und mit einer Aussparung (13) versehen ist, wobei die erste Oberfläche (111) und die zweite Oberfläche (112) einander gegenüberliegend angeordnet sind, wobei das erste leitfähige elastische Teil (401) auf der ersten Oberfläche (111) angeordnet ist;
die zweite Leiterplatte (12) zumindest teilweise auf der zweiten Oberfläche (112) gestapelt angeordnet ist, wobei die zweite Leiterplatte (12) eine dritte Oberfläche umfasst, wobei die dritte Oberfläche eine Seitenfläche der zweiten Leiterplatte (12) ist, die der ersten Leiterplatte (11) zugewandt ist, wobei die Verbinderanordnung (50) auf der dritten Oberfläche angeordnet ist, wobei die Verbinderanordnung (50) zumindest teilweise in der Aussparung (13) angeordnet ist, und wobei eine Höhe der Verbinderanordnung (50) größer ist als eine Höhe des ersten leitfähigen elastischen Teils (401).

2. Elektronische Vorrichtung nach Anspruch 1, wobei die Aussparung (13) die erste Leiterplatte (11) in einer Dickenrichtung der ersten Leiterplatte (11) durchdringt.

3. Elektronische Vorrichtung nach Anspruch 1 oder 2, wobei die zweite Leiterplatte (12) einen ersten Bereich (122) umfasst, wobei sich der erste Bereich (122) über eine Kante auf einer Seite der ersten Leiterplatte (11) hinaus erstreckt, und wobei die Verbinderanordnung (50) in dem ersten Bereich (122) angeordnet ist.

4. Elektronische Vorrichtung nach einem der Ansprüche 1 bis 3, wobei ein Teil der Verbinderanordnung (50) höher als die erste Oberfläche (111) angeordnet ist.

5. Elektronische Vorrichtung nach einem der Ansprüche 1 bis 4, wobei die zweite Leiterplatte (12) eine vierte Oberfläche (121) umfasst, und wobei die vierte Oberfläche (121) eine Seitenfläche der zweiten Leiterplatte (12) ist, die von der ersten Leiterplatte (11) weg weist.

6. Elektronische Vorrichtung nach einem der Ansprüche 1 bis 5, wobei die Verbinderanordnung (50) zumindest teilweise mit der ersten Leiterplatte (11) in der Dickenrichtung der ersten Leiterplatte (11) überlappt.

7. Elektronische Vorrichtung nach einem der Ansprüche 1 bis 6, wobei die Leiterplattenanordnung (10) ferner einen Kartenhalter (451) umfasst, wobei der Kartenhalter (451) auf der zweiten Oberfläche (112) angeordnet ist und der Kartenhalter (451) zum Einstecken einer SIM-Karte konfiguriert ist.

8. Elektronische Vorrichtung nach Anspruch 7, wobei an der Seitenwand (202) eine erste Buchse (231) vorgesehen ist und der Kartenhalter (451) ferner an der ersten Buchse (231) angeordnet ist.

9. Elektronische Vorrichtung nach Anspruch 8, wobei die elektronische Vorrichtung ferner eine Schnittstelleneinheit (452) umfasst, wobei zumindest ein Teil der Schnittstelleneinheit (452) auf einer von der ersten Oberfläche (111) abgewandten Seite der ersten Leiterplatte (11) angeordnet ist und die Schnittstelleneinheit (452) zum Einstecken eines Steckers eines externen Geräts konfiguriert ist.

10. Elektronische Vorrichtung nach Anspruch 9, wobei an der Seitenwand (202) eine zweite Buchse (232) vorgesehen ist und die Schnittstelleneinheit (452) ferner an der zweiten Buchse (232) angeordnet ist.

11. Elektronische Vorrichtung nach Anspruch 10, wobei ein Teil der Schnittstelleneinheit (452) höher als die erste Oberfläche (111) ist und ein Abstand, um den die Schnittstelleneinheit (452) höher als die erste Oberfläche (111) ist, geringer ist als die Höhe des ersten leitfähigen elastischen Elements (401).

12. Elektronische Vorrichtung nach Anspruch 11, wobei der Kartenhalter (451) und die Schnittstelleneinheit (452) zumindest teilweise höher als die vierte Oberfläche (121) sind.

13. Elektronische Vorrichtung nach einem der Ansprüche 9 bis 12, wobei die Leiterplattenbaugruppe (10) ferner ein zweites leitfähiges elastisches Element (402) umfasst, wobei das zweite leitfähige elastische Element (402) auf der vierten Oberfläche (121) angeordnet ist und eine Höhe des zweiten leitfähigen elastischen Elements (402) geringer ist als ein Abstand, um den der Kartenhalter (451) oder die Schnittstelleneinheit (452) höher als die vierte Oberfläche (121) ist.

14. Elektronische Vorrichtung nach einem der Ansprüche 7 bis 13, wobei eine Anzahl von zweiten Leiterplatten zwei beträgt, wobei zwei zweite Leiterplatten voneinander beabstandet sind und der Kartenhalter (451) zwischen den beiden zweiten Leiterplatten angeordnet ist.

15. Elektronische Vorrichtung nach einem der Ansprüche 1 bis 14, wobei sowohl die erste Leiterplatte (11) als auch die zweite Leiterplatte (12) starre Leiterplatten sind.

## Revendications

1. Un dispositif électronique, comprenant :
un boîtier (20), dans lequel le boîtier (20) comprend une paroi inférieure (201), une paroi latérale (202) et un capot arrière (22), la paroi latérale (202) est disposée à une périphérie de la paroi inférieure (201), le capot arrière (22) est relié à la paroi latérale (202), dans lequel la paroi inférieure (201), la paroi latérale (202) et le capot arrière (22) délimitent un espace de logement (203) ;
un ensemble de carte de circuit imprimé (10), dans lequel l'ensemble de carte de circuit imprimé (10) est disposé dans l'espace de logement (203), et l'ensemble de carte de circuit imprimé (10) comprend une première carte de circuit imprimé (11), une seconde carte de circuit imprimé (12), une première pièce élastique conductrice (401) et un ensemble connecteur (50) ; **caractérisé en ce que**
la première carte de circuit imprimé (11) comprend une première surface (111) et une deuxième surface (112) et est pourvue d'une ouverture d'évitement (13), la première surface (111) et la deuxième surface (112) sont disposées opposées l'une à l'autre, la première pièce élastique conductrice (401) est disposée sur la première surface (111) ;
la seconde carte de circuit imprimé (12) est au moins partiellement disposée sur la deuxième surface (112) de manière empilée, la seconde carte de circuit imprimé (12) comprend une troisième surface, la troisième surface est une surface latérale de la seconde carte de circuit imprimé (12) faisant face à la première carte de circuit imprimé (11), l'ensemble connecteur (50) est disposé sur la troisième surface, l'ensemble connecteur (50) est au moins partiellement situé dans l'ouverture d'évitement (13), et une hauteur de l'ensemble connecteur (50) est supérieure à une hauteur de la première pièce élastique conductrice (401).

2. Le dispositif électronique selon la revendication 1, dans lequel l'ouverture d'évitement (13) traverse la première carte de circuit imprimé (11) dans une direction d'épaisseur de la première carte de circuit imprimé (11).

3. Le dispositif électronique selon la revendication 1 ou 2, dans lequel la seconde carte de circuit imprimé (12) comprend une première région (122), la première région (122) s'étend au-delà d'un bord sur un côté de la première carte de circuit imprimé (11), et l'ensemble connecteur (50) est disposé dans la première région (122).

4. Le dispositif électronique selon l'une quelconque des revendications 1 à 3, dans lequel une partie de l'ensemble connecteur (50) est disposée plus haut que la première surface (111).

5. Le dispositif électronique selon l'une quelconque des revendications 1 à 4, dans lequel la seconde carte de circuit imprimé (12) comprend une quatrième surface (121), et la quatrième surface (121) est une surface latérale de la seconde carte de circuit imprimé (12) tournée à l'opposé de la première carte de circuit imprimé (11).

6. Le dispositif électronique selon l'une quelconque des revendications 1 à 5, dans lequel l'ensemble connecteur (50) chevauche au moins partiellement la première carte de circuit imprimé (11) dans la direction d'épaisseur de la première carte de circuit imprimé (11).

7. Dispositif électronique selon l'une quelconque des revendications 1 à 6, dans lequel l'ensemble de carte de circuit imprimé (10) comprend en outre un support de carte (451), le support de carte (451) est agencé sur la deuxième surface (112), et le support de carte (451) est configuré pour l'insertion d'une carte SIM.

8. Dispositif électronique selon la revendication 7, dans lequel une première prise (231) est prévue sur la paroi latérale (202), et le support de carte (451) est en outre agencé au niveau de la première prise (231).

9. Dispositif électronique selon la revendication 8, dans lequel le dispositif électronique comprend en outre une unité d'interface (452), au moins une partie de l'unité d'interface (452) est agencée sur un côté de la première carte de circuit imprimé (11) opposé à la première surface (111), et l'unité d'interface (452) est configurée pour le branchement d'une fiche d'un dispositif externe.

10. Dispositif électronique selon la revendication 9, dans lequel une deuxième prise (232) est prévue sur la paroi latérale (202), et l'unité d'interface (452) est en outre agencée au niveau de la deuxième prise (232).

11. Dispositif électronique selon la revendication 10, dans lequel une partie de l'unité d'interface (452) est plus haute que la première surface (111), et une distance de l'unité d'interface (452) dépassant la première surface (111) est inférieure à la hauteur de la première pièce élastique conductrice (401).

12. Dispositif électronique selon la revendication 11, dans lequel le support de carte (451) et l'unité d'interface (452) sont au moins partiellement plus hauts que la quatrième surface (121).

13. Dispositif électronique selon l'une quelconque des revendications 9 à 12, dans lequel l'ensemble de carte de circuit imprimé (10) comprend en outre une deuxième pièce élastique conductrice (402), la deuxième pièce élastique conductrice (402) est agencée sur la quatrième surface (121), et une hauteur de la deuxième pièce élastique conductrice (402) est inférieure à une distance du support de carte (451) ou de l'unité d'interface (452) dépassant la quatrième surface (121).

14. Dispositif électronique selon l'une quelconque des revendications 7 à 13, dans lequel le nombre de deuxièmes cartes de circuit imprimé est de deux, les deux deuxièmes cartes de circuit imprimé sont espacées l'une de l'autre, et le support de carte (451) est agencé entre les deux deuxièmes cartes de circuit imprimé.

15. Dispositif électronique selon l'une quelconque des revendications 1 à 14, dans lequel la première carte de circuit imprimé (11) et la deuxième carte de circuit imprimé (12) sont toutes deux des cartes de circuit imprimé rigides.
